# EUROPÄISCHE PATENTSCHRIFT

(11) **EP 0 923 678 B1**
(45) Veröffentlichungstag und Bekanntmachung des Hinweises auf die Patenterteilung: **22.01.2003**
(21) Anmeldenummer: 98939531.4
(22) Anmeldetag: 25.06.1998
(51) Int. Cl.: F16B 37/04, H03K 17/95

(54) **IN EINE T-NUT EINSETZBARER NÄHERUNGSSCHALTER BZW. BEFESTIGUNGSELEMENT DAFÜR**
PROXIMITY SWITCH WHICH CAN BE INSERTED IN A T-SLOT, OR FIXING ELEMENT FOR THE SAME
COMMUTATEUR DE PROXIMITE POUVANT ETRE INTRODUIT DANS UNE RAINURE EN T, ET ELEMENT DE FIXATION CORRESPONDANT

(30) Priorität: 10.07.1997 DE 19729500; 06.06.1998 DE 19825426
(43) Veröffentlichungstag der Anmeldung: 23.06.1999
(73) Patentinhaber: Werner Turck GmbH & Co. KG, D-58553 Halver (DE)
(72) Erfinder: SCHAFFNER, Norbert, CH-2854 Bassecourt (CH)
(74) Vertreter: Grundmann, Dirk, Dr.
(86) Internationale Anmeldenummer: EP9803888
(87) Internationale Veröffentlichungsnummer: WO99002871

(56) Entgegenhaltungen:
- DE-A- 4 115 253
- DE-U- 29 700 737
- FR-A- 2 624 569

## Beschreibung

Die Erfindung betrifft ein Befestigungselement für einen in eine T-Nut einsetzbaren Näherungsschalter bzw. einen Näherungsschalter mit derartigem Befestigungselement gemäß dem Gattungsbegriff der Ansprüche 1 oder 6.

Näherungsschalter sind in vielfacher Form im Stand der Technik bekannt. Sie wirken induktiv oder kapazitiv und reagieren insbesondere auf die Anwesenheit von in die Nähe des Auslösers eines Näherungsschalters gebrachtem Metall, insbesondere Eisen. In einem speziellen Anwendungsfall werden Näherungsschalter als Abfrageelement an einem Pneumatikzylinder montiert, um die Kolbenstellung abzufragen. Geeignete Pneumatikzylinder weisen an ihrem Gehäuse in Verlagerungsrichtung des Pneumatikorganes verlaufende Befestigungsnuten auf. Diese Befestigungsnuten besitzen einen T-förmigem Querschnitt und werden deshalb als T-Nuten bezeichnet. Die Nutwände haben eine C-förmige Querschnittskontur. Sie besitzen einen Nutboden und an der Nutöffnung nuteinwärtsgerichtete Rippen, so daß die Nutöffnung schmaler ist als der Nutboden. Bringt man einen Näherungsschalter mit einer T-förmigen Grundplatte in eine derartige Nut ein, so kann man den Näherungsschalter innerhalb der Nut verschieben. Er ist zufolge seiner Formgestaltung gegen einseitliches Herausfallen aus der Nut gesichert. Soll ein derartiger Näherungsschalter in der Nut fixiert werden, so wird ein Schraubbolzen - mit oder ohne Gewindekopf - in eine entsprechende Gewindebohrung der Tragplatte des Näherungsschalters eingeschraubt, um gegen den Nutgrund verschraubt zu werden, so daß sich der Näherungsschalter zwischen den Rippen und dem Nutgrund einklemmt.

Der Erfindung liegt die Aufgabe zugrunde, Mittel anzugeben, um einen gattungsgemäßen Näherungsschalter einfacher montieren zu können.

Gelöst wird die Aufgabe durch die in den Ansprüchen angegebene Erfindung.

Das erfindungsgemäße Befestigungselement erlaubt es, daß die Grundplatte des Näherungsschalters gegen den Nutgrund verspannt wird. Besitzt der Schraubkopf darüber hinaus noch Abflachungen, deren Abstand voneinander geringer ist als die lichte Weite der Nut, so kann von der Einschubmontage abgesehen werden. Der Näherungsschalter ist dann an jeder beliebigen Stelle der T-Nut mit seiner als der Rippenabstand schmalerer Befestigungsplatte in die T-Nut einsteckbar. Durch eine Schraubbetätigung wird dann der Kopf entweder zusammen mit dem Gewindebolzen aus dem Muttergewinde herausgedreht oder als Mutter gestaltet, auf den Gewindebolzen gedreht. Die vorzugsweise zur Gewindegangsteigung entgegengerichteten Steigungsflächen des Schraubenkopfes untergreifen dann die Rippen, so daß der Näherungsschalter in einen Klemmsitz gebracht wird, wobei die Grundfläche des Näherungsschalters auf der Bodenfläche der Nut bleibt. In einer Weiterbildung der Erfindung ist vorgesehen, daß der Gewindebolzen ein Linksgewinde besitzt. Entsprechend dieser Ausgestaltung haben die Steigungsflächen die Form eines Rechtsgewindes. Eine Betätigung des Befestigungselementes in Rechtsdrehrichtung führt dann dazu, daß sich der Bolzen aus dem Muttergewinde herausschraubt und gleichzeitig die Steigungsflächen in eine Untergriffslage unter die Rippen verlagern. Dadurch, daß zwei Steigungsflächen vorgesehen sind, die um 180 Grad höhengleich gegeneinander versetzt liegen, werden beide Rippen gleichermaßen zur Verspannung beigezogen. Der Schraubkopf hat in etwa die äußere Form eines Hutes, deren Krempe die Steigungsflächen ausbilden, wobei die Krempe an zwei gegenüberliegenden Seiten abgeflacht unterbrochen ist. Die Steigungsflächen sind vorzugsweise keilförmig ausgebildet. Ein erfindungsgemäßer Näherungsschalter besitzt eine größte Breite, die kleiner ist als die lichte Weite der Nut, so daß der Näherungsschalter von seitwärts her in die Nut eingesetzt werden kann. Der Schraubkopf des Befestigungselementes besitzt entsprechende Abflachungen, deren Abstand in etwa der Näherungsschalterbreite entspricht, so daß der Näherungsschalter mit in Parallellage zur Längserstreckung des Näherungsschalters gebrachten Abflachungen von seitwärts her in die Nut eingesetzt werden kann. Bevorzugt besitzt der Näherungsschalter einen in Längsrichtung sich erstreckenden Befestigungsabschnitt, dessen Höhe geringer ist als die Tiefe der Nut und welcher Befestigungsabschnitt mit einem Muttergewinde versehen ist, in welches das Befestigungselement einschraubbar ist. Der Näherungsschalter kann mit einem oder zweien derartiger Befestigungselementen ausgebildet sein. So kann beispielsweise an jedem Ende des Näherungsschalters ein Befestigungselement angeordnet sein. Der Kopf, der zuvor als Kopf einer Schraube beschrieben worden ist, kann aber auch von einer Mutter ausgebildet werden. Der Gewindebolzen kann dann fest mit dem Befestigungsabschnitt verbunden sein. Der Kopf kann dann einen Flansch besitzen, welcher in Achsrichtung zugängliche Schraubwerkzeugeingriffsprofile aufweist. Hierdurch ist seine erhöhte Sicherheit gegeben, wenn die Schraubwerkzeugangriffsprofile nur von speziell gestalteten Schraubwerkzeugen zugänglich sind. Die feste Verbindung zwischen Gewindebolzen und Befestigungsabschnitt hat darüber hinaus noch den Vorteil, daß der Gewindebolzen relativ lang gestaltet werden kann. Vorteilhaft ist es auch, wenn die Steigung der Steigungsflächen größer ist als die Steigung des Gewindes. Dann braucht die Keilsteigungsrichtung der Steigungsfläche nicht einmal einen anderen Drehsinn zu besitzen als die Steigung des Gewindeganges. Auch kann auf einen Gewindebolzen vollständig verzichtet werden. Es kann ausreichen, daß der die Steigungsflächen aufweisenden Kopf lediglich gegenüber dem Befestigungsabschnitt drehbar ist, damit die Steigungsflächen in Angriff unter die Nutrippen bringbar sind. Die hammerkopfartige Ausgestaltung des Kopfes ermöglicht die Einsteckmontage.

Ein Ausführungsbeispiel der Erfindung wird nachfolgend anhand beigefügter Zeichnungen erläutert. Es zeigen:
- Fig. 1: einen erfindungsgemäßen Näherungsschalter, eingebaut in eine T-Nut in der Perspektive,
- Fig. 2: eine Darstellung gemäß Fig. 1 in Kopfansicht in der vormontierten Stellung,
- Fig. 3: eine Darstellung gemäß Fig. 2 in der Klemmstellung,
- Fig. 4: eine Draufsicht in der Einsteckstellung,
- Fig. 5: eine Darstellung gemäß Fig. 4 in der Klemmstellung,
- Fig. 6: einen Schnitt gemäß der Linie VI-VI in Fig. 5,
- Fig. 7: einen Schnitt gemäß der Linie VII-VII in Fig. 6 und,
- Fig. 8: ein weiteres Ausführungsbeispiel der Erfindung in einer Querschnittsdarstellung gemäß Fig. 7.

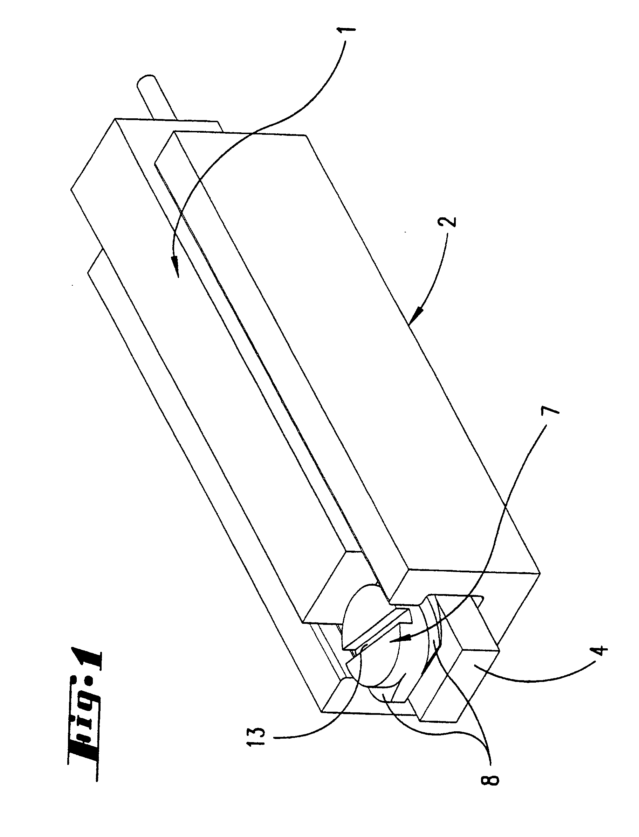

In der Fig. 1 ist ausschnittsweise das Gehäuse 2 eines Pneumatikzylinders dargestellt, insoweit, wie es hier von Interesse ist. Das Gehäuse 2 zeigt eine T-förmige Nut 3. In dieser T-Nut 3 ist ein Näherungsschalter 1 eingesetzt. Der Näherungsschalter 1 besitzt eine Weite, die dem lichten Abstand der beiden Rippen 11 entspricht, die die T-förmige Nut 3 zur Nutöffnung hin abschließt. Auf dem Nutgrund 12 der T-Nut 3 liegt der Näherungsschalter 1 mit seiner Grundfläche auf.

Der Näherungsschalter 1 besitzt ein Gehäuse 10, in welchem in bekannter Weise der Auslöser, eine Schwellwertschaltung und weitere nachfolgende elektronische Schaltkreise untergebracht sind. In Längsrichtung besitzt das Näherungsschaltergehäuse 10 einen Befestigungsabschnitt 4, welcher als Fortsatz ausgebildet ist, und welcher eine Höhe hat, die geringer ist als die Tiefe der Nut 3. Dieser Befestigungsabschnitt 4 besitzt ein Muttergewinde 5 mit linksgängigem Sinn. In dieses Muttergewinde 5 kann der Gewindebolzen 6 eines Befestigungselementes eingeschraubt werden.

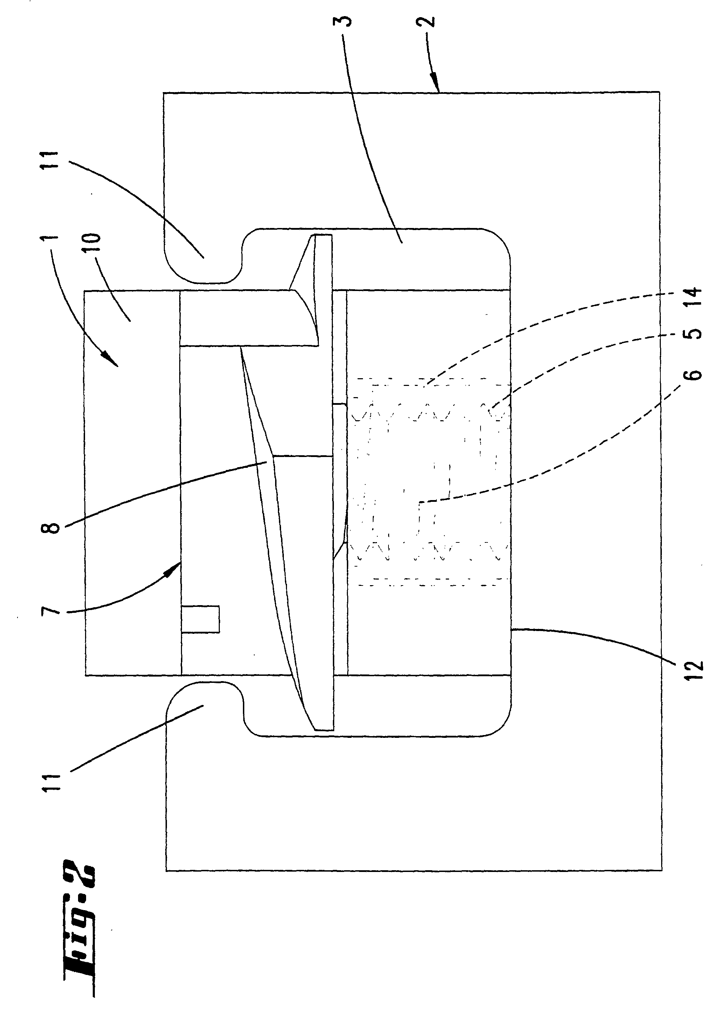

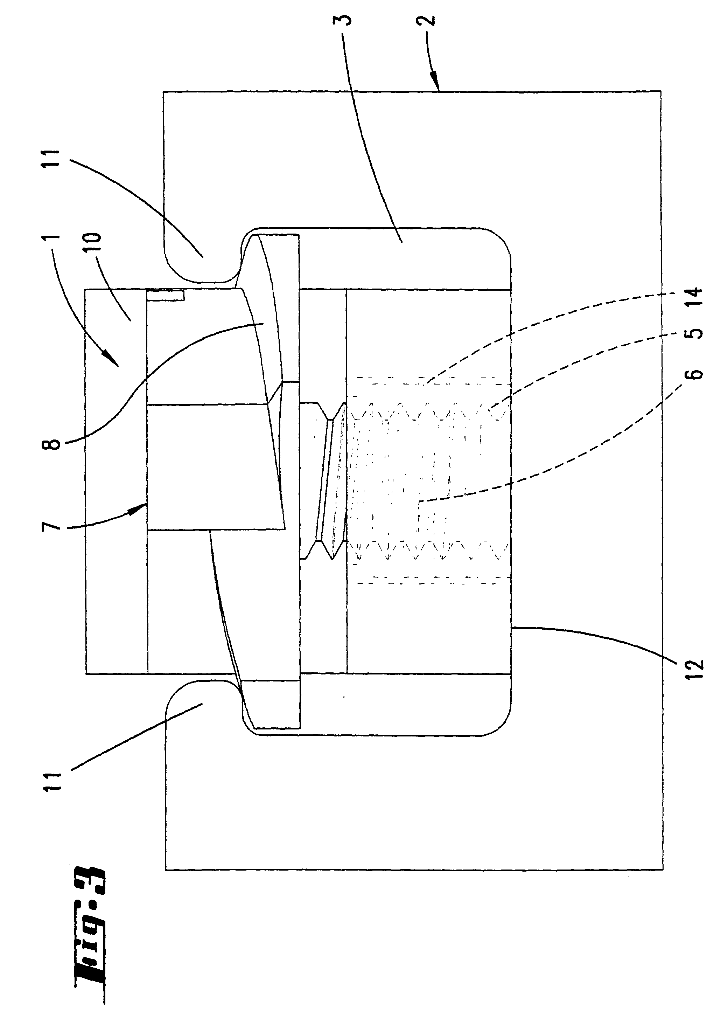

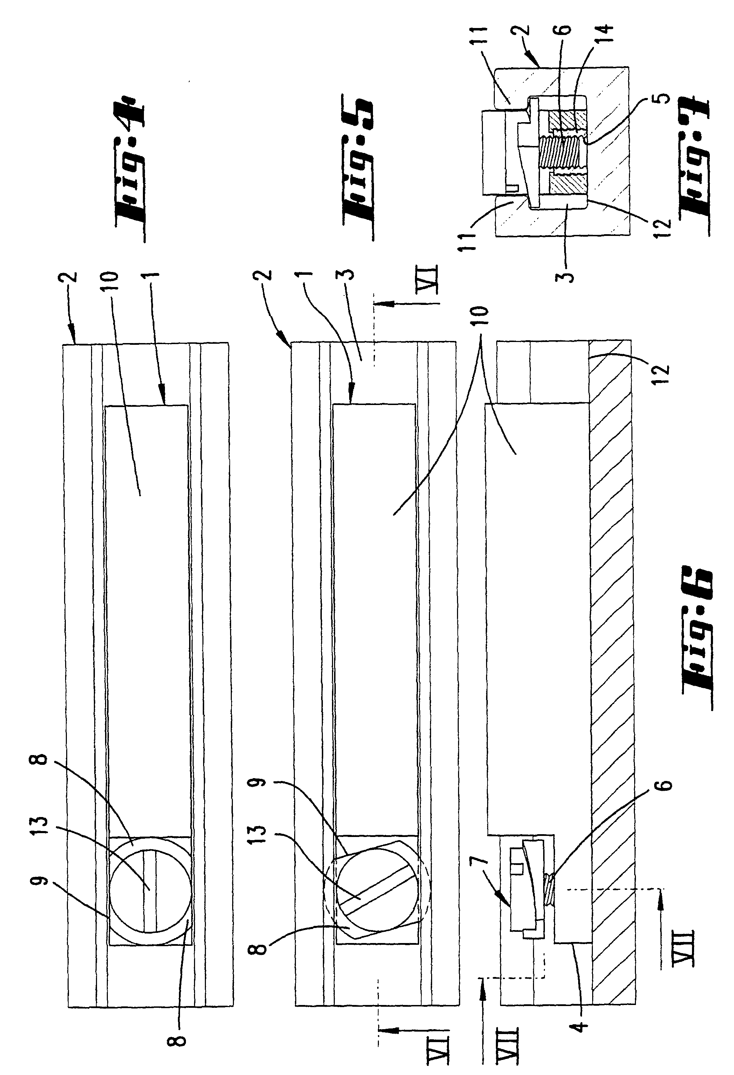

Das Befestigungselement besitzt den besagten Gewindebolzen mit einem Linksgewinde. Der Gewindebolzen 6 geht über in einen Schraubenkopf 7, welcher eine Hutform besitzt. Die Krempen des Hutes werden von Steigungsflächen 8 ausgebildet. Es sind insgesamt zwei Steigungsflächen 8 vorgesehen, welche um 180 Grad versetzt zueinander einander gegenüberliegen und keilförmig geformt sind. Die Steigungsflächen 8 sind voneinander durch Abflachungen 9 getrennt. Die Abflachungen 9 liegen einander gegenüber und sind parallel zueinander. Der Abstand der Abflachungen 9 entspricht in etwa der Breite des Gehäuses 10. Der Abstand der Abflachungen 9 ist jedoch geringer als der Abstand der beiden Rippen 11. Der Außendurchmesser, der drehkeilförmigen Steigungsflächen 8, ist größer als die lichte Weite zwischen den beiden Rippen 11, so daß diese beiden rechtsgängigen Steigungsflächen 8 beim Verdrehen des Befestigungselementes aus einer Position gemäß Fig. 4 unter die Rippen gelangen und zufolge des Sich-Heraus-Drehens des Gewindebolzens 6 aus dem Muttergewinde 5 in eine Klemmlage unter die Rippen verlagern, wobei die gegensinnige Steigung der auf der gewindebolzenabgeneigten Seite angeordneter Steigungsflächen 8 unterstützend wirkt.

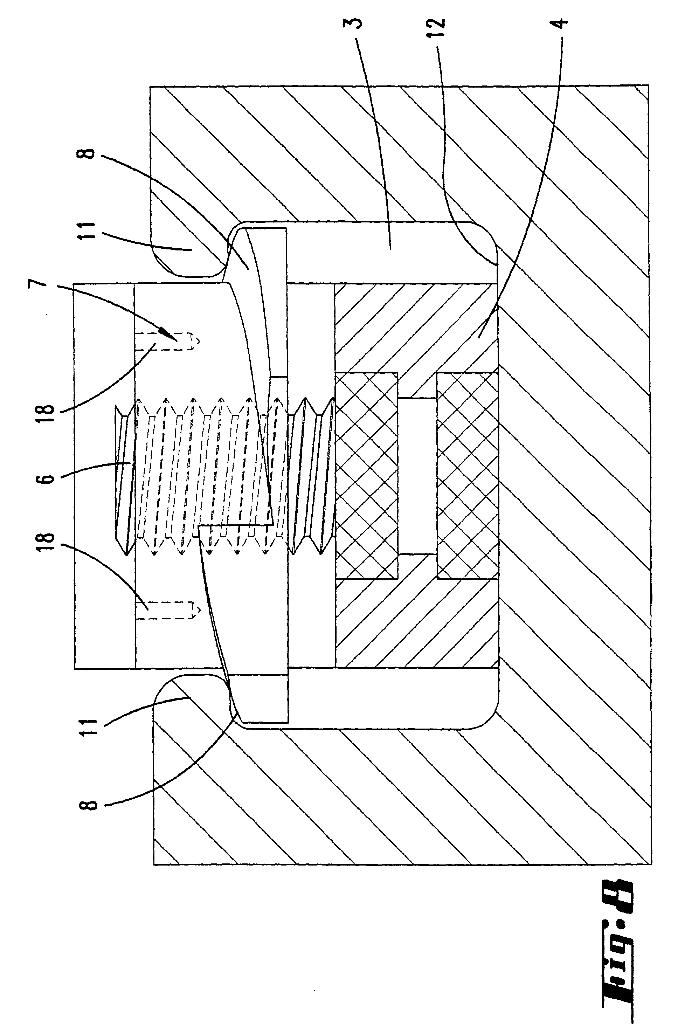

In Fig. 7 ist dargestellt, daß das Muttergewinde 5 einem Gewindenippel 14 zugeordnet ist, welcher im Befestigungsabschnitt 4 sitzt.

In dem zuvor beschriebenen Ausführungsbeispiel besitzt das Gewinde des Gewindebolzens 6 eine Steigungsrichtung, die entgegengesetzt gerichtet ist zur Steigungsrichtung der Steigungsflanken 8. Es ist aber auch vorgesehen, daß die Steigungsflächen 8 eine größere Steigung besitzen als die Steigung des Gewindes des Gewindebolzens 6. Dann ist es nicht einmal erforderlich, daß der Gewindebolzen 6 und die Steigungsflächen 8 eine entgegengesetzte Steigungsrichtung besitzen. Es kann sogar völlig auf eine Drehlagerung des Befestigungselementes auf einem Gewindebolzen 6 verzichtet werden.

Wird aber eine Gewindelagerung des Kopfes gewählt, so erweist es sich von besonderem Vorteil, wenn die Steigung der Steigungsflächen 8 größer ist als die Steigung des Gewindes des Gewindebolzens 6. Hierdurch können alle Toleranzen im Abstand zwischen Nutrippe 11 und Nutboden 12 ausgeglichen werden.

Bei dem in Fig. 8 dargestellten Ausführungsbeispiel ist der Gewindebolzen 6 fest mit dem Befestigungsabschnitt 4 verbunden. Auf dem Gewindebolzen 6 ist ein als Mutter ausgebildeter Kopf 7 aufgeschraubt. Die krempenartigen Steigungsflächen 8 des Kopfes 7 entsprechen der zuvor beschriebenen Ausgestaltung. Stirnseitig besitzt der Kopf 7 einen Flanschabschnitt mit Öffnungen 18 zum Einbringen von Mitnahmezapfen eines Schraubwerkzeuges.

Ein derartig ausgebildeter Näherungsschalter kann insbesondere in Nuten an (pneumatischen) Zylindern angebracht werden. Es ist aber auch möglich, den Näherungsschalter in dieser Form an verschiedensten Vorrichtungen, beispielsweise Antrieben, Füllstandsüberwachungen usw. anzubringen.

## Patentansprüche

1. Befestigungselement für einen mit einem Befestigungsabschnitt (4) in einer nuteinwärts gerichteten, Nutrippen (11) aufweisenden T-Nut durch Schraubbetätigung verklemmbaren Näherungsschalter, **dadurch gekennzeichnet, dass** der drehbare Kopf (7) des Befestigungselementes randseitig zwei einander gegenüberliegende Steigungsflächen (8) aufweist, die zum Verspannen des Befestigungsabschnittes (4) zwischen Nutboden (12) und Nutrippen (11) durch Verdrehen des Kopfes (7) in eine Untergriffslage unter die Nutrippen (11) bringbar sind.

2. Befestigungselement nach Anspruch 1 **dadurch gekennzeichnet, daß** die Steigungsrichtung der Steigungsflächen (8) der Steigungsrichtung des Schraubgewindes entgegen gerichtet ist.

3. Befestigungselement nach einem der vorhergehenden Ansprüche **dadurch gekennzeichnet, daß** die Steigungsflächen (8) durch zwei parallel zueinander verlaufende Abflachungen (9) voneinander getrennt sind.

4. Befestigungselement nach einem der vorhergehenden Ansprüche **dadurch gekennzeichnet, daß** ein Gewindebolzen (6) der Schraubanordnung ein Linksgewinde trägt.

5. Befestigungselement nach einem der vorhergehenden Ansprüche, **dadurch gekennzeichnet, daß** der Kopf (7) die Form eines Hutes besitzt, deren Krempe die Steigungsflächen (8) ausbildet.

6. Befestigungselement nach einem der vorhergehenden Ansprüche, **dadurch gekennzeichnet, daß** die Steigungsflächen (8) um 180 Grad höhengleich gegeneinander versetzt sind.

7. Befestigungselement nach einem der Ansprüche 4 bis 6 **dadurch gekennzeichnet, daß** der Kopf (7) fest am Gewindebolzen (6) sitzt, welcher in einem Muttergewinde (5) einschraubbar ist.

8. Befestigungselement nach einem der vorhergehenden Ansprüche, **dadurch gekennzeichnet, daß** der Kopf (7) als Mutter ausgebildet ist und auf einem fest am Befestigungsabschnitt (4) sitzenden Gewindebolzen (6) aufgeschraubt ist.

9. Befestigungselement nach einem der Ansprüche 4 bis 8, **dadurch gekennzeichnet, daß** die Steigung der Steigungsflächen (8) größer ist als die Gewindesteigung des Gewindebolzens (6).

10. Befestigungselement nach einem der vorhergehenden Ansprüche **dadurch gekennzeichnet, daß** der als Mutter ausgebildete Kopf (7) stirnseitige Schraubwerkzeugangriffsprofilierungen ausbildet.

11. In eine nuteinwärts gerichtete, Nutrippen (11) aufweisende T-Nut einsteckbarer Näherungsschalter mit einem einen Kopf (7) und einen Gewindebolzen (6) aufweisenden Befestigungselement zum Verspannen des Befestigungsabschnittes (4) des Näherungsschalters (1) zwischen Nutboden (12) und Nutrippen (11), **dadurch gekennzeichnet, dass** der Kopf (7) des Befestigungselementes randseitig zwei einander gegenüberliegende Steigungsflächen (8) aufweist, die durch Verdrehen des Kopfes (7) in eine Untergriffslage unter die Nutrippen (11) bringbar sind.

12. Befestigungselement oder Näherungsschalter nach einem der vorhergehenden Ansprüche, **dadurch gekennzeichnet, daß** die Steigungsflächen durch eine Abflachung (9) derart voneinander getrennt sind, daß der Kopf (7) bei in Parallellage zur Nuterstreckung gebrachten Abflachungen (9) durch den zwischen den Nutrippen (11) belassenen Freiraum hindurch steckbar ist.

13. Befestigungselement oder Näherungsschalter nach einem der vorhergehenden Ansprüche, **dadurch gekennzeichnet, daß** das Befestigungselement einem mit einem Muttergewinde (5) versehenen Befestigungsabschnitt (4) zugeordnet ist.

14. Befestigungselement oder Näherungsschalter nach Anspruch 13, **dadurch gekennzeichnet, daß** das Muttergewinde von einem Gewindenippel (14) ausgebildet wird.

15. Befestigungselement oder Näherungsschalter nach einem der vorhergehenden Ansprüche, **dadurch gekennzeichnet, daß** die Steigungsflächen (8) schraubengangförmig ausgebildet sind.

16. Befestigungselement oder Näherungsschalter nach einem der vorhergehenden Ansprüche, **dadurch gekennzeichnet, daß** die Steigungsflächen (8) die Schrägflächen eines Drehkeiles mit ebener, zur Gewindeachse senkrechter Grundfläche sind.

## Claims

1. Fastening element for a proximity switch which can be clamped by screw actuation to a fastening section (4) in a T-slot having slot ledges (11) pointing towards the inside of the slot, **characterised in that** the rotatable head (7) of the fastening element has at the edge two sloping faces (8) opposite one another, which can be brought into a position for gripping underneath the slot ledges (11) to clamp the fastening section (4) between slot floor (12) and slot ledges (11) by rotating the head (7).

2. Fastening element according to claim 1, **characterised in that** the direction of the slope of the sloping faces (8) is pointing against the direction of the slope of the screw thread.

3. Fastening element according to one of the preceding claims, **characterised in that** the sloping faces (8) are separated from one another by two flattened areas (9) running parallel to one another.

4. Fastening element according to one of the preceding claims, **characterised in that** a threaded bolt (6) of the screw arrangement bears a left thread.

5. Fastening element according to one of the preceding claims, **characterised in that** the head (7) has the shape of a hat, the brim of which forms the sloping faces (8).

6. Fastening element according to one of the preceding claims, **characterised in that** the sloping faces (8) are offset in respect of one another by 180 degrees at identical height.

7. Fastening element according to one of claims 4 to 6, **characterised in that** the head (7) fits tightly to the threaded bolt (6), which can be screwed into an internal screw thread (5).

8. Fastening element according to one of the preceding claims, **characterised in that** the head (7) is constructed as a nut and is screwed on to a threaded bolt (6) fitting tightly to the fastening section (4).

9. Fastening element according to one of claims 4 to 8, **characterised in that** the slope of the sloping faces (8) is greater than the slope of the thread of the threaded bolt (6).

10. Fastening element according to one of the preceding claims, **characterised in that** the head (7), constructed as a nut, forms engagement contours at the front for screwing tools.

11. Proximity switch, able to be inserted into a T-slot, having slot ledges (11) pointing to the inside of the slot, with a fastening element, having a head (7) and a threaded bolt (6), for clamping the fastening section (4) of the proximity switch (1) between slot floor (12) and slot ledges (11), **characterised in that** the head (7) of the fastening element has at the edge two sloping faces (8) opposite one another, which can be brought into a position for gripping underneath the slot ledges (11) by rotating the head (7).

12. Fastening element or proximity switch according to one of the preceding claims, **characterised in that** the sloping faces are separated from one another by a flattened area (9) in such a way that the head (7) can be inserted through the open space left between the slot ledges (11) when the flattened areas (9) are brought into a parallel position to the extension of the slot.

13. Fastening element or proximity switch according to one of the preceding claims, **characterised in that** the fastening element is assigned to a fastening section (4) provided with an internal screw thread (5).

14. Fastening element or proximity switch according to claim 13, **characterised in that** the internal screw thread is constructed by a threaded nipple (14).

15. Fastening element or proximity switch according to one of the preceding claims, **characterised in that** the sloping faces (8) are constructed in the shape of turns.

16. Fastening element or proximity switch according to one of the preceding claims, **characterised in that** the sloping faces (8) are the oblique faces of a rotating wedge with a flat base perpendicular to the axis of the thread.

## Revendications

1. Elément de fixation pour un interrupteur de proximité pouvant être bloqué par serrage, par actionnement par vissage avec une découpe de fixation (4) dans une rainure en T présentant des nervures de rainure (11) et tournées vers l'intérieur de la rainure, **caractérisé en ce que** la tête rotative (7) de l'élément de fixation présente en bordure deux faces de pente (8) opposées l'une à l'autre pouvant être placées en position de saisie par le dessous sous les nervures de rainure (11) pour obtenir le serrage du tronçon de fixation (4) entre le fond de rainure (12) et les nervures de rainure (11), par une rotation de la tête (7).

2. Elément de fixation selon la revendication 1, **caractérisé en ce que** le centre de pente des faces de pente (8) est orienté dans le sens inverse du sens de pente du filetage.

3. Elément de fixation selon l'une des revendications précédentes, **caractérisé en ce que** les faces de pente (8) sont séparées l'une de l'autre par deux méplats (9) s'étendant parallèlement l'un à l'autre.

4. Elément de fixation selon une ou plusieurs des revendications précédentes, **caractérisé en ce qu'**un boulon fileté (6) de l'agencement du dispositif de vissage porte un filetage à gauche.

5. Elément de fixation selon l'une des revendications précédentes, **caractérisé en ce que** la tête (7) a la forme d'un chapeau dont le rebord forme les faces de pente (8).

6. Elément de fixation selon l'une ou plusieurs des revendications précédentes, **caractérisé en ce que** les faces de pente (8) sont décalées l'une par rapport à l'autre à hauteur égale de 180 degrés.

7. Elément de fixation selon l'une des revendications 4 à 6, **caractérisé en ce que** la tête (7) est montée rigidement sur le boulon fileté (6) qui est susceptible d'être vissé dans un filetage d'écrou (5).

8. Elément de fixation selon l'une des revendications précédentes, **caractérisé en ce que** la tête (7) est réalisée sous la forme d'écrou et est vissée sur un boulon fileté (6) monté rigidement sur le tronçon de fixation (4).

9. Elément de fixation selon l'une des revendications 4 à 8, **caractérisé en ce que** le pas des faces de pente (8) est supérieur au pas de filetage du boulon fileté (6).

10. Elément de fixation selon l'une des revendications précédentes, **caractérisé en ce que** la tête (7) réalisée sous la forme d'écrou forme des profilages d'emprise d'outils de vissage sur le côté frontal.

11. Interrupteur de proximité pouvant être enfiché dans une rainure en T présentant des nervures de rainure (11) orientées vers l'intérieur, l'interrupteur étant muni d'un élément de fixation présentant une tête (7) et un boulon fileté (6) pour assurer le serrage du tronçon de fixation (4) de l'interrupteur de proximité (1) entre le fond de rainure (12) et les nervures de rainure (11), **caractérisé en ce que** la tête (7) de l'élément de fixation présente en bordure deux faces de pente (8) opposées l'une à l'autre pouvant être placées en position de saisie par le dessus sous les nervures de rainure (11) par une rotation de la tête (7).

12. Elément de fixation ou interrupteur de proximité selon l'une des revendications précédentes, **caractérisé en ce que** les faces d'inclinaison sont séparées les unes les autres par un méplat (9), de manière que la tête (7) puisse être enfichée dans l'espace libre laissé entre les nervures de rainure (11) lorsque les méplats (9) sont placés parallèlement à la direction longitudinale de la rainure.

13. Elément de fixation ou interrupteur de proximité selon l'une des revendications précédentes, **caractérisé en ce que** l'élément de fixation est associé à un tronçon de fixation (9) muni d'un filetage d'écrou (5).

14. Elément de fixation ou interrupteur de proximité selon la revendication 13, **caractérisé en ce que** le filetage d'écrou est formé par un embout fileté (14).

15. Elément de fixation ou interrupteur de proximité selon l'une des revendications précédentes, **caractérisé en ce que** les faces d'inclinaison (8) sont en forme de filet de vis.

16. Elément de fixation ou interrupteur de proximité selon l'une des revendications précédentes, **caractérisé en ce que** les faces d'inclinaison (8) sont les faces obliques d'un coin rotatif ayant une face de base plane perpendiculaire à l'axe de filetage.
